# NEUE EUROPÄISCHE PATENTSCHRIFT

(11) **EP 0 454 686 B2**
(45) Veröffentlichungstag und Bekanntmachung des Hinweises auf die Entscheidung über den Einspruch: **26.08.1998**
(45) Hinweis auf die Patenterteilung: 29.09.1993
(21) Anmeldenummer: 90900062.2
(22) Anmeldetag: 21.12.1989
(51) Int. Cl.: B23B 27/14, C23C 14/04, C23C 14/44, C23C 16/04, C23C 16/50

(54) **SCHNEIDEINSATZ UND VERFAHREN ZU SEINER HERSTELLUNG**
CUTTING INSERT AND PROCESS FOR MANUFACTURING IT
GARNITURE DE COUPE ET SON PROCEDE DE FABRICATION

(30) Priorität: 28.01.1989 DE 3902532
(43) Veröffentlichungstag der Anmeldung: 06.11.1991
(73) Patentinhaber: Krupp Widia GmbH, 45145 Essen (DE)
(72) Erfinder: KÖNIG, Udo, D-4300 Essen 1 (DE)
(74) Vertreter: Vomberg, Friedhelm, Dipl.-Phys.
(86) Internationale Anmeldenummer: DE8900786
(87) Internationale Veröffentlichungsnummer: WO9008613

(56) Entgegenhaltungen:
- EP-A- 6 534
- EP-A- 089 818
- EP-A- 298 729
- EP-A- 309 648
- EP-A- 323 434
- EP-A- 0 199 527
- EP-A- 0 275 975
- AP-P- 2 609 598
- AT-C- 269 598
- CH-A- 516 371
- DD-A- 132 932
- DD-A- 230 022
- DD-B- 125 141
- DD-B- 151 010
- DE-A- 3 020 929
- DE-B- 2 263 210
- DE-U- 8 529 043
- JP-A-55 137 803
- US-A- 3 836 392
- US-A- 3 836 392
- US-A- 3 882 579
- US-A- 3 882 581
- Z. Werkstofftechnik" 17, 1986 Seiten 109-114
- Patent Abstract of Japan, Vol. 8, Nr 114,C225 ; abstract bis JP 59-28565, publ. 1984-02-15 (SUMITOMO DENKI KOGYO K.K.)
- Derwent's abstract, Nr. 89-90 923/12, JP 1 042 574, publ. week 8912 (NEC CORP)
- Derwent's abstract, Nr. 88-350 421/49, JP 63 262 462, publ.week 8849 (UBE INDUSTRIES KK)
- Derwent's abstract, Nr. 73-262 430/19, NL 7 302 515, publ.week 7319 (WILKINSON SWORD LTD)
- Ceramic-Coated Cutting Tools, SAE Technical Paper Series, Copyright 1981
- Werkstofftechnik 17 (1986), Seiten 109-114

## Beschreibung

Die Erfindung betrifft einen Schneideinsatz nach dem Oberbegriff des Anspruches 1 oder 3 und ein Verfahren zu seiner Herstellung nach Anspruch 8.

Es ist allgemein bekannt, daß das grundlegende Problem bei Hartmetalleinsätzen darin liegt, zum einen hinreichend harte und gleichzeitig zähe Werkstoffe zu finden. Zur Verbesserung der Verschleißfestigkeit ist man daher dazu übergegangen, Schneidwerkzeuge aus Hartmetall mit Titancarbid, Titancarbonitrid und/oder Titannitrid zu beschichten. Zum Beispiel in der DE-PS 22 63 210 ist auch schon eine Mehrlagenbeschichtung aus Titancarbid, Titancarbonitrid und Titannitrid vorgeschlagen worden. Solche Beschichtungen haben sich bei Schneidwerkzeugen bewährt, die für die Drehbearbeitung von Stählen bei mittleren Schnittgeschwindigkeiten eingesetzt werden. Ebenfalls ist bekannt, zusätzlich die Lebensdauer von Schneidwerkzeugen dadurch zu erhöhen, daß auf ihnen dünne Schichten aus Aluminiumoxid aufgebracht werden.

Nachteilig ist jedoch, daß durch die Beschichtung die Biegefestigkeit der Schneideinsätze abnimmt. Dies führt beim Arbeiten im unterbrochenen schnitt bisweilen sogar zum Plattenbruch, dadurch die Zerspanungskraft auf einer Wendeschneidplatte auf deren Spanfläche (Oberseite) eine Zugspannung und auf der gegenüberliegenden Seite (Unterseite) eine Druckspannung entsteht. Die Auslösung eines Bruches erfolgt daher von dem Spanflächeninnenteil aus.

In der CH-PS 516 371 wird zwar ein Schneideinsatz zu spanabhebenden Bearbeitung aus einem Hartmetallkörper mit einer 2 bis 6 µm dicken Oberflächenbeschichtung aus Titancarbid und/oder einer festen Lösung aus Titancarbid und anderen Carbiden beschrieben, das bzw. die eine mittlere Korngröße von 0,1 bis 0,6 µm hat; die Oberflächenbeschichtung soll mindestens die Schneidkante oder -kanten und die damit in Verbindung stehenden spanabhebenden Flächen bedecken, im allgemeinen auch die übrigen Flächen oder die Arbeitsfläche oder -flächen, vorzugsweise die Einspann- und Abstützflächen, während die Schneidkanten frei bleiben. Jedoch wird in dieser Druckschrift nicht ausgeführt, wie breit die Beschichtung ausgeführt sein soll und mit welchem Verfahren die Schneideinsätze herstellbar sind.

Weiterhin wird in der EP-A-0 006 534 davon gesprochen, daß wenigstens die beanspruchten Seiten beschichtet sein sollen, jedoch werden in der Aufgabenstellung drei wesentliche Eigenschaften benannt, namentlich die Oxidationsbeständigkeit, der Reibungskoeffizient sowie die Gleichmäßigkeit der Oberfläche, die nur den Schluß zulassen, daß eine vollflächige Beschichtung der Span- und Freifläche angestrebt wird.

Aus der EP-A-0 298 729 sind die Stellen bekannt, an denen ein Schneideinsatz, der mit Titancarbid, Titannitrid und/oder Oxiden bzw. Oxinitriden aus Aluminium und Zirkon beschichtet ist, einem Verschleiß unterliegt. Die EP-A-0 275 975 betrifft einen Hartmetall- oder Keramikgrundkörper mit einer vollständig dichten, fest verbundenen verschleißbeständigen Mehrfachbeschichtung, die im wesentlichen aus drei übereinanderliegenden Oxidschichten unterschiedlicher Zusammensetzung bestehen soll. Soweit dort eine oder mehrere Unterbrechnungen zugelassen sind, sollen die anliegenden Schichten durch diese Unterbrechnung miteinander verbunden sein, d.h. durchgehend sein.

Aus SAE Technical Paper Series 1981, Seite 23 bis 27, "Ceramic-Coated Cutting Tools" sind Untersuchungen über mit TiC beschichteten Schneideinsätzen bekannt, bei denen die aufgetragene Al₂O₃-Beschichtung durch Honen im an die Schneidkante angrenzenden Spanflächenbereich und Freiflächenbereich vollständig entfernt worden ist, ggf. mit der Maßgabe, daß auch die Beschichtung auf der Spanfläche oder auf der Freifläche (alternativ) vollständig abgetragen wird. Im Ergebnis war jedoch die Verschleißbeständigkeit der Schneideinsätze, bei denen nur die Schneidkantenbereiche und die Spanfläche und die Schneidkantenbereiche durch Honen wieder abgetragen worden sind, schlechter als die der vollständig beschichteten Schneideinsätze. Ein nachträgliches Abtragen der Beschichtung führt somit nach dieser Untersuchung nicht zu verbesserten Schneideinsätzen.

Aus der JP-A-55-137803 ist ein teilbeschichteter Schneideinsatz bekannt, bei dem die Dicke der Beschichtung auf der Spanfläche von der Schneidkante zur Spanflächenmitte hin derart verjüngt wird, daß die Schichtdicke in der Spanflächenmitte faktisch Null wird. Dies soll durch Verwendung von Abdeckplatten, die bei der Beschichtung in einem geringen Abstand über der Spanfläche angeordnet werden, erreicht werden.

Es ist daher Aufgabe der vorliegenden Erfindung, Schneideinsätze, insbesondere Wendeschneidplatten einer besseren Zähigkeit zu schaffen, ohne daß deren Verschleißeigenschaften schlechter werden.

Diese Aufgabe wird durch einen Schneideinsatz nach Anspruch 1 oder 3 gelöst. Weiterbildungen dieser Erfindung sind in den Ansprüchen 2 und 4 bis 7 beschrieben.

Unter wirksamer Schneidkante wird der durch den ablaufenden Span belastete Spanflächenbereich bezeichnet.

Diese Weiterbildungen betreffen zum einen die Geometrie der beschichteten Flächen als auch die Beschichtung selbst. Bei allen der in den Unteransprüchen aufgeführten Geometrien wird der Grundsatz verfolgt, daß so wenig Flächen wie nötig beschichtet werden, andererseits die Einschränkung der Beschichtung nicht zu Lasten einer an den Schneidkanten benötigten Werkzeughärte führen darf. Insbesondere muß ein Abplatzen oder Ausbrechen der Beschichtung vermieden werden.

Die herkömmlichen bekannten Beschichtungsverfahren, wie CVD oder PVD, erfordern neben der Apparatur noch nicht unerhebliche Heizenergien, was die Herstellung der beschichteten Wendeschneidplatten verteuert.

Es ist daher ferner Aufgabe der vorliegenden Erfindung, ein Verfahren zu finden, mit dem eine bessere Ausnutzung der Beschichtungsanlage möglich ist.

Diese Aufgabe zur Herstellung des Schneideinsatzes wird durch die im Anspruch 8 beschriebenen Verfahrensschritte gelöst. Die Abdeckung der Flächen, die nicht beschichtet werden sollen, bewirkt eine nicht unerhebliche Materialersparnis.

Vorzugsweise wird das sogenannte Plasma-CVD angewendet, was den Vorteil hat, daß die einzelnen Schneideinsätze, mit oder ohne Distanzstücke, ohne weitere Druckaufbringung aufeinandergestapelt werden können. Das sogenannte Plasma-CVD-Verfahren arbeitet mit einer niedrigen Abscheidetemperatur. In einem Plasma einer Niederdruckglimmentladung besteht die Gasmischung aus Neutralteilchen, Molekülen, dissoziierten Molekülen, Ionen und Elektronen. Wegen des Ungleichgewichtszustandes bei der Niederdruckentladung sind die Temperaturen der Neutralteilchen einige tausend Grad niedriger als die Elektronentemperaturen. Hierdurch werden chemische Reaktionsprozesse aktiviert. Ein Niederdruckplasman kann beispielsweise durch eine Gleichspannung oder durch eine hochfrequente Wechselspannung bei Drücken zwischen 10 und 1000 Pascal erzeugt werden.

Vorzugsweise wird jedoch das sogenannte Puls-Plasma-CVD-Verfahren angewandt, wobei nach einer Weiterbildung der Erfindung die Plasmaaktivierung an der als Katode geschalteten Schneideinsatz durch eine gepulste Gleichspannung mit einer in den Pulspausen verbleibenden Restspannung einer Größe durchgeführt wird, die gleich oder größer als das niedrigste Ionisierungspotential der beteiligten Gase des CVD-Prozesses, maximal jedoch 50 % des maximalen Wertes der gepulsten Gleichspannung ist.

Die gepulste Gleichspannung ist im Regelfall eine Rechteckspannung mit einer maximalen Amplitude zwischen 200 und 900 Volt und einer Periodendauer zwischen 20 µm und 20 ms. Abweichungen von der Rechteckspannung wie Ausbildung von nicht senkrechten Anstiegs- und Abfallflanken sowie Dachschrägen sind ebenso denkbar, sofern die Bedingung erfüllt bleibt, daß zwischen zwei maximalen Spannungswerten die Gleichspannung nicht auf Null sinkt, sondern stets oberhalb des niedrigsten Ionisierungspotentials der beteiligten Gase und unterhalb von 50 % der maximalen Spannungsauslenkung bleibt. Vorzugsweise wird ein Verhältnis der (mittleren) Restgleichspannung zur maximalen gepulsten Gleichspannung zwischen 0,02 und 0,5 eingestellt. Nach einer Weiterbildung der Erfindung liegt das Verhältnis der Pulslänge (Dauer des positiven Spannungssignals eines Pulses) zu der zwischen zwei Pulsen liegenden Pulspause zwischen 0,1 und 0,6. Bei Abscheidetemperaturen zwischen 400 und 600°C sollte die Schichtwachstumsgeschwindigkeit zwischen 0,5 bis 10 µm/h liegen.

Die Schneideinsätze werden ohne Distanzstücke unmittelbar übereinandergestapelt, wobei bei der Stapelung darauf geachtet werden muß, daß die jeweils anliegenden Flächen gerade die Flächen bedecken, die nicht beschichtet werden sollen. Dies bedeutet z.B. bei in der Grundfläche viereckigen Wendeschneidplatten, daß die Wendeschneidplatten um 90° versetzt aufeinandergelegt werden, so daß jeweils nur die Ecken freiliegend sind. Im Falle von positiven Freiwinkeln führt die kleinere Grundfläche (Unterseite) der Wendeschneidplatte beim Aufeinanderstapeln zweier gleich groß dimensionierter Wendeschneidplatten ohnehin dazu, daß nur der mittlere Teil der Oberseite der Wendeschneidplatte bedeckt ist. Selbstverständlich wäre es auch möglich, Wendeschneidplatten verschiedener Größen und/oder Formen gleichzeitig zu beschichten, wobei jedoch darauf zu achten ist, daß die Wendeschneidplatten von der größten bis zur kleinsten hin sortiert übereinandergestapelt werden müssen.

Ausführungsbeispiele der Erfindung sollen anhand der Zeichnungen erläutert werden. Es zeigen
- Fig. 1 bis 3: jeweils viereckige Wendeschneidplatten mit vollständig beschichteten Freiflächen, aber nur teilweise beschichteter Spanfläche in perspektivischer Darstellung,
- Fig. 4 und 5: Wendeschneidplatten entsprechend Fig. 1 bis 3, jedoch mit nur teilweise beschichteten Freiflächen,
- Fig. 6, 6a und 6b: jeweils verschiedene Ansichten einer Wendeschneidplatte mit abgesetzter wirksamer Spanfläche und
- Fig. 7a bis 7b: jeweils Anordnungen von Wendeschneidplatten während der CVD- oder PVD-Beschichtung.

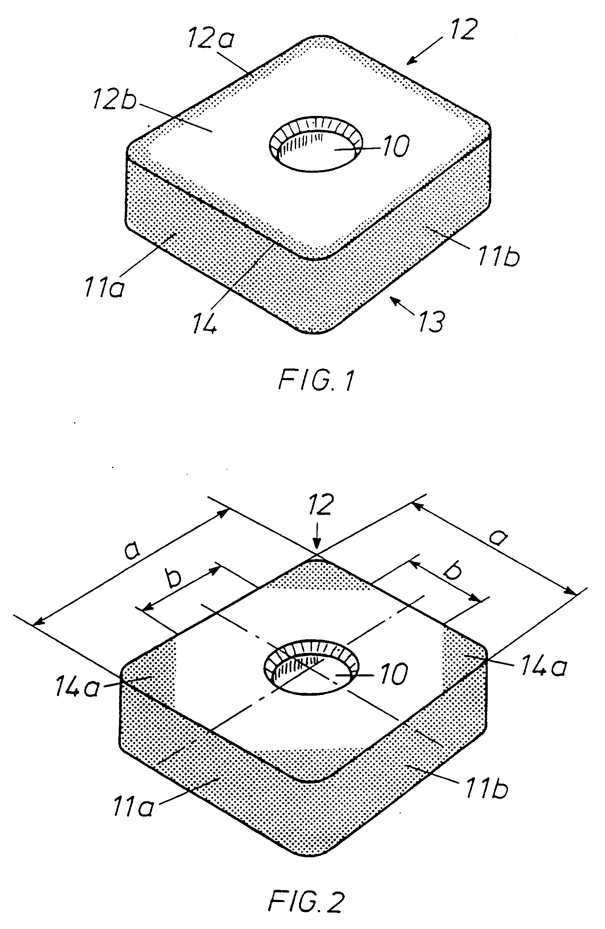

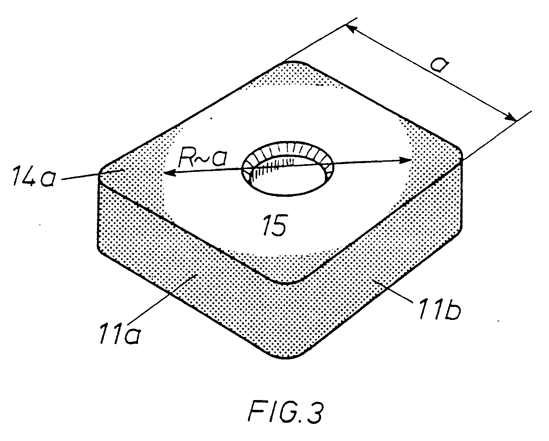

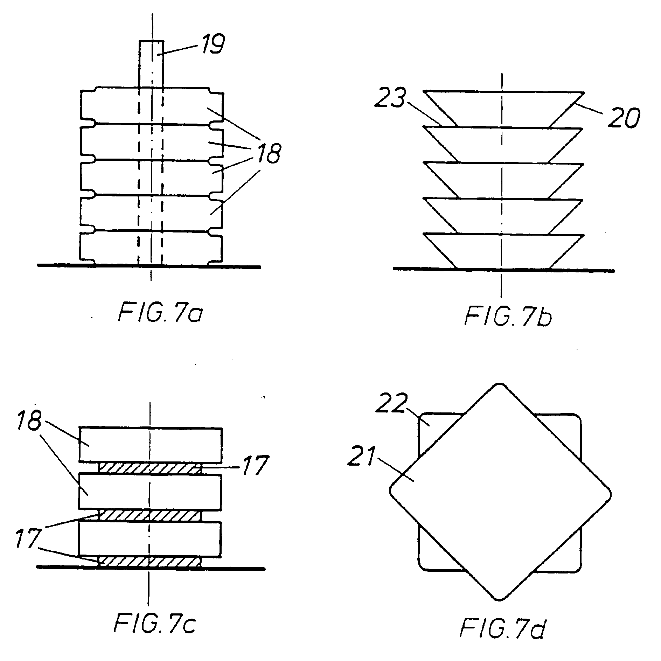

Die nicht unter Schutz gestellte, in Fig. 1 dargestellte viereckige Wendeschneidplatte besteht aus einer oberen und einer unteren Spanfläche 12 bzw. 13 sowie jeweils mit diesen Schneidkanten 14 bildenden Freiflächen, von denen in den Figuren nur zwei mit Bezugszeichen 11a und 11b bezeichnete Flächen sichtbar sind. Im Unterschied zu den vollständig ein- oder mehrlagig beschichteten Wendeschneidplatten besitzt diese Wendeschneidplatte einen unbeschichteten Flächenanteil 12b bzw. auf der gegenüberliegenden Unterseite 13 einen entsprechend großen Anteil 13b. Hierbei handelt es sich um eine Hauptfläche der Wendeschneidpatte im Werkzeugträger, die beim Schneiden erheblichen Zug- und Druckspannungen ausgesetzt ist. In einem im wesentlichen die an die Schneidkanten 14 angrenzenden Randbereiche ist die Wendeschneidplatte beschichtet (siehe Bereich 12a). Während bei der Wendeschneidplatte nach Fig. 1 der Randbereich im wesentlichen gleichbleibend breit ist, sind nach der Ausführungsform nach Fig. 2 die Ober- und die Unterseite jeweils nur im Bereich der Schneidkantenecke beschichtet, wobei das dortige Beschichtungsdreieck jeweils Schneidkantenstrecken a - b aufweist, die mindestens so groß wie der in Fig. 2 dargestellte Schneidkantenabschnitt b sind, an dem sich eine unbeschichtete Fläche der Ober- bzw. Unterseite anschließt. Die in Fig. 2 dargestellte Wendeschneidplatte kann z.B. dadurch hergestellt werden, daß die gleich großen viereckigen Wendeschneidplatten 21 und 22 nach dem Schema der Fig. 7d um 90° verdreht aufeinandergelegt werden. Jeweils an der oberen und der unteren Spanfläche bleiben hierbei dreieckförmige Flächenstücke unbedeckt, die beschichtet werden. Nach der vorliegenden Erfindung sind jedoch (entgegen der Darstellung in Fig. 2 und 3) nur solche Schneideinsätze beansprucht, deren Freiflächen nur dort beschichtet sind, wo sich an die angrenzende Schneidkante 14 ein beschichteter Spanflächenbereich 14a anschließt.

Fig 1 und 2 stellen keine Ausführungsformen der beanspruchten Erfindung dar.

Eine weitere Beschichtungsmöglichkeit ist in Fig. 3 dargestellt, wo der unbeschichtete Teil der oberen Spanfläche kreisförmig ausgebildet ist und der Kreisradius etwa der Schneidkantenlänge a entspricht. Nach der beanspruchten Erfindung sind jedoch (entgegen der Darstellung) die Freiflächen nur in dem and die wirksame Schneidkante (14) anschließenden Bereich mittels CVD oder PVD beschichtet.

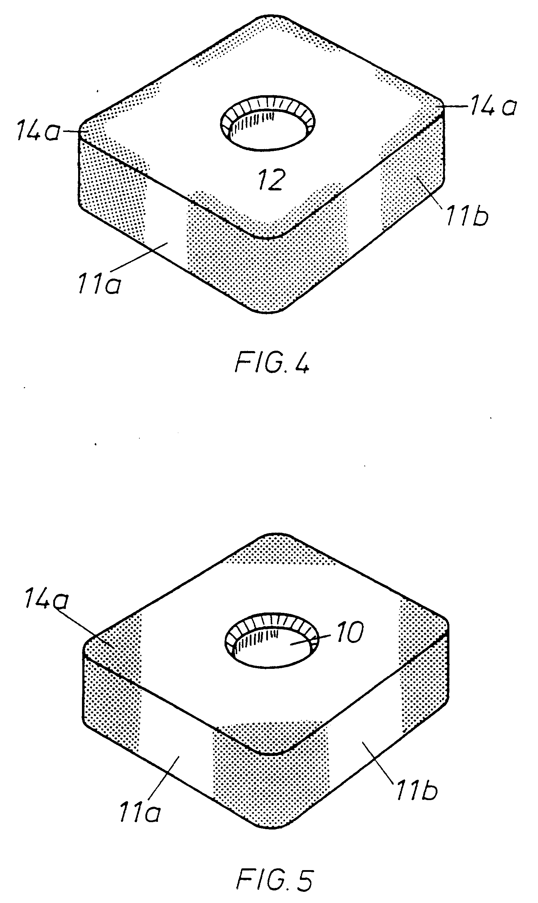

Während in den Fig. 1 bis 3 die Freiflächen 11a und 11b vollständig beschichtet worden sind, ist nach der Ausführungsform in Fig. 4 und 5 ein mittlerer Flächenbereich ausgespart worden. Dieser liegt etwa in Höhe des mittleren Bereiches, der in Fig. 2 mit einer Breite b charakterisiert ist. Somit sind jeweils die Eckbereiche 14a und die darunterliegenden Freiflächenbereiche nur beschichtet, wobei die Spanflächenbeschichtung, wie in Fig. 4 dargestellt, in etwa gleichbleibend breit nur am Rand oder dreieckförmig (Fig. 5) ausgeführt sein kann. Für Beschichtungen nach Fig. 1, Fig. 3 sowie Fig. 4 und 5 wird man mit den schematisch in Fig. 7c dargestellten Distanzstücken 17 arbeiten, die ggf. die Wendeschneidplatten auch an den Seitenwänden 11a, b seitlich umfassen.

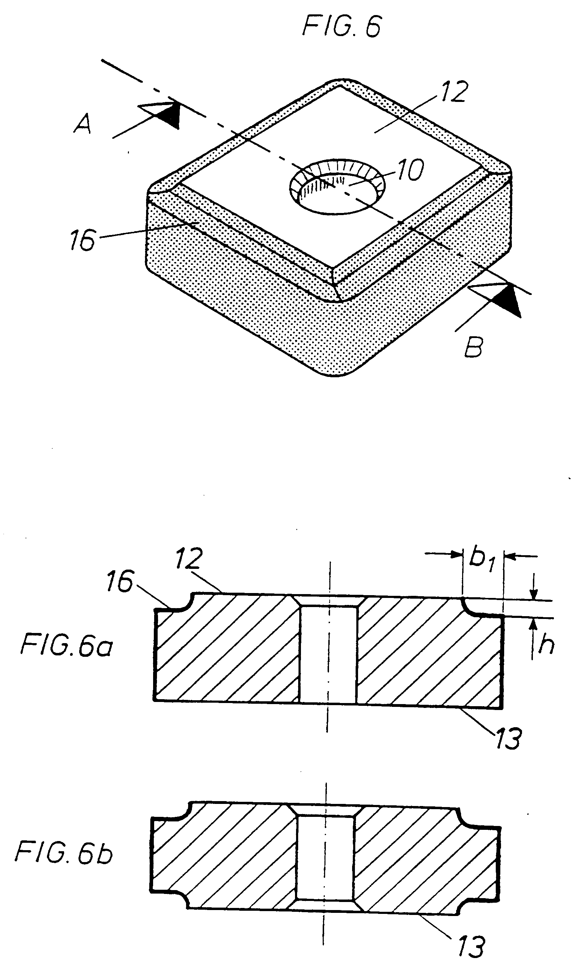

Ganz ohne Distanzstücke kann man hingegen auskommen, wenn man eine Wendeschneidplatte nach Fig. 6, 6a oder 6b verwendet.

Dort sind die Spanflächen 16 stufenförmig von der übrigen planen Spanfläche 12 abgesetzt, ggf. kann eine hierzu symmetrische Ausgestaltung der unteren Auflagefläche (Fig. 6b) gewählt werden. Die Stufenhöhe h und die Stufenbreite b1 sollten so gewählt werden, daß ein guter Spanfluß erreicht wird.

Eine mögliche Anordnung der in Fig. 6 und 6b dargestellten Wendeschneidplatten während des Beschichtens ist Fig. 7a zu entnehmen. Die dort dargestellten Wendeschneidplatten 18 liegen im Bereich ihrer planen Spanflächen 12 und 13 aneinander an, wobei eine Zentrierung durch den Dorn 19 herbeigeführt ist, über den sie geschoben sind. Der Dorn 19 entspricht in seinem Radius etwa dem des Befestigungsloches 10.

Wendeschneidplatten mit positivem Freiwinkel 20 sind in Fig. 7b dargestellt: Stellt man diese Wendeplatten übereinander, so ergibt sich zwangsläufig auf der Spanfläche ein nicht bedeckter Randbereich 23, der neben den jeweiligen Freiflächen beschichtet werden wird. Die untere Auflagefläche bleibt vollständig unbeschichtet.

Weitere alternative Beschichtungsmöglichkeiten sind in Fig. 7c und Fig. 7d ausgeführt, wo im einen Fall mit Distanzstücken 17, im anderen Fall durch Übereinanderstapeln jeweils gegeneinander um 90° versetzter Wendeschneidplatten 21, 22 gearbeitet wird. Selbstverständlich kann dieses Stapelverfahren auch bei anderen als viereckigen Wendeschneidplatten eingesetzt werden, die Drehung sollte dann 360/n betragen, wobei n die Zahl der Ecken ist. Zur Beschichtung können im Prinzip die bekannten CVD- bzw. PVD-Prozesse verwendet werden, wobei jedoch dem Plasma-CVD-Prozeß insbesondere, wie oben beschrieben, oder dem PVD-Prozeß der Vorzug gegeben wird.

Fig. 7c stellt keine Ausführungsform der Erfindung dar

## Patentansprüche

1. Schneideinsatz mit verminderter Bruchempfindlichkeit, insbesondere Wendeschneidplatte, bestehend aus einem mit einer Teiloberflächenbeschichtung aus Carbiden, Nitriden und/oder Carbonitriden, insbesondere des Titans und/oder aus Al₂O₃ versehenen Hartmetall-Grundkörper, dessen Spanfläche nur in dem sich an die wirksame Schneidkante anschließenden Bereich mittels PVD oder CVD beschichtet ist,
**dadurch gekennzeichnet,**
daß bei ganz oder nur in dem sich an die wirksame Schneidkante (14) anschließenden Bereich beschichteter Freiflächen der wirksame beschichtete Spanflächenbereich stufenförmig abgesetzt ist.

2. Schneideinsatz nach Anspruch 1, gekennzeichnet, durch eine sich an die Schneidkanten (14) anschließende, vorzugsweise im wesentlichen gleichbleibend breite Randbeschichtung (12a) der Spanfläche(n) (12, 13).

3. Schneideinsatz mit verminderter Bruchempfindlichkeit, insbesondere Wendeschneidplatte, bestehend aus einem mit einer Teiloberflächenbeschichtung aus Carbiden, Nitriden und/oder Carbonitriden, insbesondere des Titans und/oder aus Al₂O₃ versehenen Hartmetall-Grundkörper, dessen Spanfläche nur in dem sich an die wirksame Schneidkante anschließenden Bereich mittels PVD oder CVD beschichtet ist, dadurch gekennzeichnet, daß die Spanfläche nur im Bereich der Schneidecken beschichtet ist, und daß die Freiflächen nur dort beschichtet sind, wo sich an die angrenzende Schneidkante (14) ein beschichteter Spanflächenbereich (12a, 14a) anschließt, wobei die beschichtete Schneidkantenecke (14a) im wesentlichen gleichschenklig dreieckig ist oder nur eine im wesentlichen gleichbleibend breite Randbeschichtung der Spanfläche in einem sich an die Schneidkante anschließenden Bereich vorgesehen ist.

4. Schneideinsatz nach Anspruch 3, gekennzeichnet durch eine beschichtete Schneidkantenecke (14a) mit einer von der Beschichtung begrenzten Schneidkantenstrecke (a -b), die mindestens so groß wie der übrige Schneidkantenabschnitt (b) auf derselben Kante ist, dem sich eine unbeschichtete Fläche anschließt.

5. Schneideinsatz nach Anspruch 3 oder 4, dadurch gekennzeichnet, daß ein sich bis an die Schneidkanten erstreckender und alle Schneidkanten tangierender Kreis (15) der Spanfläche(n) (12, 13) unbeschichtet, alle anderen Flächen (11a, b, 14a) jedoch beschichtet sind.

6. Schneideinsatz nach einem der Ansprüche 2 bis 5, dadurch gekennzeichnet, daß die Breite der Beschichtung bis zu 15 % der Schneidkantenlänge (a) beträgt.

7. Schneideinsatz nach einem der Ansprüche 1 bis 6, dadurch gekennzeichnet, daß die Beschichtung mehrlagig ist und vorzugsweise eine Lage aus Al₂O₃ aufweist.

8. Verfahren zur Teiloberflächenbeschichtung eines Schneideinsatzes nach Ansprüchen 1 bis 7, mittels CVD oder PVD, dadurch gekennzeichnet, daß die zu beschichtenden Schneideinsätze (18) ohne Distanzstücke so übereinander gestapelt werden, daß sie, bedingt durch ihren positiven Freiwinkel (20) oder durch gegenseitige Verdrehung (21, 22) gegeneinander sich gegenseitig im Bereich der Spanfläche (12, 13) abdecken.

## Claims

1. Cutting insert with reduced sensitivity to fracture, in particular a reversible cutting disc, comprising a hard metal body having a partial surface coating of carbides, nitrides and/or carbonitrides, in particular of titanium and/or Al₂O₃, the face of which is coated by means of PVD or CVD only in the area adjoining the active cutting edge, characterised in that when the flanks are coated fully or only in the area adjoining the active cutting edge (14), the active coated face area is stepped.

2. Cutting insert according to Claim 1, characterised by an edge coating (12a) of the face(s) (12, 13), which adjoins the cutting edges (14) and preferably has an essentially constant width.

3. Cutting insert with reduced sensitivity to fracture, in particular a reversible cutting disc, comprising a hard metal body having a partial surface coating of carbides, nitrides and/or carbonitrides, in particular of titanium and/or Al₂O₃, the face of which is coated by means of PVD or CVD only in the area adjoining the active cutting edge, characterised in that the face is only coated in the area of the corners, and that the flanks are only coated at the point where a coated face area (12a, 14a) adjoins the adjacent cutting edge (14), whereby the coated corner (14a) is essentially in the form of an isosceles triangle, or only an edge coating of the face with an essentially constant width is provided in an area adjoining the cutting edge.

4. Cutting insert according to Claim 3, characterised by a coated corner (14a) with an area (a - b) of the cutting edge, which is bordered by the coating and is at least as large as the remaining section of the cutting edge (b) on the same edge, to which an uncoated area adjoins.

5. Cutting insert according to Claim 3 or 4, characterised in that a circle (15) of the face(s) (12, 13), which extends as far as the cutting edges and to which all the cutting edges form a tangent, is uncoated, whereas all other surfaces (11a, b, 14a) are coated.

6. Cutting insert according to one of Claims 2 to 5, characterised in that the width of the coating amounts to up to 15% of the length (a) of the cutting edge.

7. Cutting insert according to one of Claims 1 to 6, characterised in that the coating is multi-layered and preferably has a layer of Al₂O₃.

8. Process for the partial surface coating of a cutting insert according to Claims 1 to 7 by means of CVD or PVD, characterised in that the cutting inserts (18) to be coated are stacked one above the other without spacers so that they cover each other in the area of the face (12, 13) as a result of their positive clearance (20) or of their being shifted in relation to one another (21, 22).

## Revendications

1. Garniture de coupe, présentant une sensibilité réduite à la rupture, en particulier plaquette réversible de coupe, constituée d'un corps de base en métal dur, comportant un revêtement de surface partiel en carbures, en nitrures et/ou en carbonitrures, en particulier de titane, et/ou en Al₂O₃, dont la surface de coupe est revêtue, au moyen des procédés CVD ou PVD, seulement dans la zone voisine de l'arête de coupe agissante,
caractérisée en ce que, dans le cas de surfaces de dépouille recouvertes en totalité ou seulement dans la zone se raccordant à l'arête de coupe (14) agissante, la zone revêtue agissante présente un retrait formant gradin.

2. Garniture de coupe suivant la revendication 1, caractérisée par un revêtement du bord (12a) de la surface, ou des surfaces, des facettes de coupe (12, 13) au voisinage de l'arête de coupe agissante (14), ce revêtement de bordure ayant essentiellement une largeur constante.

3. Garniture de coupe présentant une sensibilité réduite à la rupture, en particulier plaquette réversible de coupe, constituée d'un corps de base en métal dur, comportant un revêtement de surface partiel en carbures, en nitrures et/ou en carbonitrures, en particulier de titane, et/ou en Al₂O₃, dont la surface de coupe est revêtue, au moyen des procédés CVD ou PVD, seulement dans la zone voisine de l'arête de coupe agissante, caractérisée en ce que la surface de coupe est revêtue seulement dans la zone des coins de coupe et en ce que les surfaces de dépouille sont seulement revêtues là où une zone de surface de coupe revêtue (12a, 14a) se raccorde la l'arête de coupe (14) voisine, le coin revêtu (14a) de l'arête de coupe ayant essentiellement une forme de triangle isocèle, ou bien un revêtement en bordure d'une largeur essentiellement constante étant seulement prévu dans une zone se raccordant à l'arête de coupe.

4. Garniture de coupe suivant la revendication 3, caractérisée par un coin revêtu (14a) de l'arête de coupe comportant une partie d'arête de coupe (a - b) voisine du revêtement, qui est au moins aussi grande que le reste de la partie d'arête de coupe (b) située sur la même arête, à laquelle se raccorde une surface non revêtue.

5. Garniture de coupe suivant la revendication 3 ou la revendication 4, caractérisée en ce qu'un cercle (15) de la ou des surfaces de coupe (12, 13), s'étendant jusqu'aux arêtes de coupe et tangent à toutes les arêtes de coupe, n'est pas revêtu, alors que toutes les autres surfaces (11a, b, 14a) sont revêtues.

6. Garniture de coupe suivant l'une des revendications 2 à 5, caractérisée en ce que la largeur du revêtement a une valeur allant jusqu'à 15% de la longueur (a) de l'arête de coupe.

7. Garniture de coupe suivant l'une des revendications 1 à 6, caractérisée en ce que le revêtement est en plusieurs couches et présente, de préférence, une couche d'Al₂O₃.

8. Procédé de revêtement partiel de la surface d'une garniture de coupe suivant les revendications 1 à 7, au moyen du procédé CVD ou PVD, caractérisé en ce que les garnitures de coupe (18) à revêtir sont mises en pile les unes au-dessus des autres sans pièces d'écartement, de façon à se recouvrir les unes les autres dans la zone de la surface de coupe (12, 13), face contre face, de façon déterminée par leur angle de dépouille positif (20), ou par une rotation des unes par rapport aux autres (21, 22).
